# EUROPÄISCHE PATENTANMELDUNG

(11) **EP 1 079 672 A2**
(43) Veröffentlichungstag der Anmeldung: **28.02.2001**
(21) Anmeldenummer: 00116943.2
(22) Anmeldetag: 07.08.2000
(51) Int. Cl.: H05K 1/00

(54) **Kunststofformteil mit elektrischen Kontakten**

(30) Priorität: 13.08.1999 DE 19937865
(71) Anmelder: Ticona GmbH, 65451 Kelsterbach (DE)
(72) Erfinder: Platz, Reinhold G., 64367 Mühltal (DE)

(57) **Zusammenfassung**

Kunststofformteil, das auf einer Seite auf seiner Oberfläche elektrische Leiterbahnen (5) aufweist, in die Kontaktstifte (3) eingebracht sind, wobei ein Teil dieser Kontaktstifte von der Oberfläche mit den elektrischen Leiterbahnen absteht und ein Teil der Kontaktstifte durch die Kunststoffschicht hindurch dringt und auf der anderen, entgegengesetzten Seite herausragt sowie Baugruppe umfassend ein Gehäuse (1) aus mindestens einem thermoplastischen Kunststoff oder Kunststoff-Blend, das an ausgewählter Stelle an seiner Innenseite auf der Oberfläche elektrische Leiterbahnen (5) aufweist, in die Kontaktstifte (3) eingebracht sind, wobei ein Teil dieser Kontaktstifte von der Oberfläche mit den elektrischen Leiterbahnen absteht und ein Teil der Kontaktstifte durch die Kunststoffschicht des Gehäuses hindurch dringt und ausschließlich oder zusätzlich auf der entgegengesetzten Außenseite herausragt, sowie mindestens eine elektrische oder elektronische Vorrichtung.

## Beschreibung

Die vorliegende Erfindung betrifft ein Formteil aus thermoplastischem Kunststoff mit elektrischen Kontakten sowie ein Verfahren zu seiner Herstellung. Das erfindungsgemäße Formteil enthält integrierte Leiterbahnen und Kontaktstifte und kann insbesondere als Gehäuse für elektrische oder elektronische Vorrichtungen verwendet werden.

Weitläufig bekannt sind Platinen für elektrische Schaltungen, die auf ihrer Oberfläche elektrische Leiterbahnen tragen, an die elektronische Bauteile wie Transistoren, Relais, Computerchips etc. angelötet sind. Die Platinen sind in der Regel aus einem elektrisch isolierenden Kunststoff gefertigt.

Bekannt sind auch Steckverbinder aus Kunststoff, die zu einer Seite Kontaktstifte oder Kontakthülsen aufweisen, die in den Kunststoff eingegossen oder eingesteckt sind. An der anderen (Rück-) Seite der Kontaktstifte oder Kontakthülsen sind elektrische Leitungen befestigt, die in der Regel zu einem Kabel zusammengeführt werden. Diese Steckverbinder enthalten jedoch keine elektrischen Leiterbahnen, die verschiedene der Kontaktstifte oder Kontakthülsen miteinander verbinden.

Bauteile für elektrische oder elektronische Vorrichtungen sind üblicherweise so aufgebaut, daß beispielsweise ein Elektromotor, eine elektrische Schaltung etc. von einem Gehäuse umgeben ist. Die elektrische Kontaktierung geschieht dabei meist durch ein Kabel, das durch eine Öffnung im Gehäuse hindurchgeführt und direkt oder mit Hilfe eines Steckverbinders mit der elektrischen oder elektronischen Vorrichtungen verbunden wird.

Besonders in der Maschinen- und Fahrzeugtechnik gibt es eine Menge Beispiele für derartige Baugruppen: Verteilerboxen, Boxen für Sicherungen und Boxen für spezielle Fahrzeugelektronik, jeweils bestehend aus einem Gehäuse, einer Platine mit elektrischen Schaltungen und Bauteilen und einer separaten Stromzuführung, die durch eine Öffnung im Gehäuse geführt wird, sowie Gehäuse für Türschlösser, Fensterheber- oder Scheibenwischergetriebe, die u.a. einen Elektromotor und eine durch das Gehäuse geführte Stromzuleitung enthalten.

Ein Problem, das hierbei auftritt, ist oft ein ungenügender Schutz der elektrischen oder elektronischen Bauteile vor Feuchtigkeit, da die Kabeldurchführungen der Stromzuleitungen meist, oder wenn vorgesehen nicht dauerhaft paßgenau sind und eine separate Abdichtung nicht vorgenommen wird. Andererseits ist durch das Einfädeln der Stromzuführung, den Anschluß des Kabelendes der Stromzuführung an die im Inneren des Gehäuses befindliche und ggf. befestigte elektrische oder elektronische Vorrichtungen eine Vielzahl von Arbeitsschritten für die Montage nötig.

Es bestand nun die Aufgabe, eine alternative Möglichkeit zur Fertigung elektrischer oder elektronischer Baugruppen zu finden, die möglichst auch die Montage vereinfacht.

Diese Aufgabe wird erfindungsgemäß dadurch gelöst, daß ein Kunststofformteil, welches im Spritzgießverfahren hergestellt wird, bereitgestellt wird, das auf einer Seite elektrische Leiterbahnen enthält, in bzw. durch die Kontaktstifte eingebracht sind, wobei ein Teil der Kontaktstifte auf der anderen, entgegengesetzten Seite herausragen.

Die Erfindung betrifft daher ein Kunststofformteil, das auf einer Seite auf seiner Oberfläche elektrische Leiterbahnen enthält, in die Kontaktstifte eingebracht sind, wobei ein Teil dieser Kontaktstifte von der Oberfläche mit den elektrischen Leiterbahnen absteht und ein Teil der Kontaktstifte durch die Kunststoffschicht hindurch dringt und auf der anderen, entgegengesetzten Seite herausragt.

Die Erfindung betrifft auch ein Verfahren zur Herstellung des erfindungsgemäßen Formteils, das im folgenden näher beschrieben wird, sowie insbesondere die Verwendung des erfindungsgemäßen Formteils als Gehäuse für elektrische oder elektronische Vorrichtungen.

Das erfindungsgemäße Formteil vereint die Funktionen eines Gehäuses und einer Platine. Seine Vorteile bestehen beispielsweise darin, daß das Gehäuse keine Öffnung zur Durchführung der Stromzuleitung benötigt und somit ein vollständiger Feuchtigkeitsausschluß im Inneren des Gehäuses, wo sich die Leiterbahnen und die elektrische oder elektronische Vorrichtung befinden, gewährleistet werden kann. Stromzuleitungen können zudem in einfacher Weise außen am Gehäuse auf durch herausragende Kontaktstifte gebildete Steckverbindungen aufgesteckt werden.

Im Inneren des Gehäuses kann durch das Design der Leiterbahnen sowie zusätzlich durch Aufstecken elektronischer Teile oder Baugruppen auf die Kontaktstifte eine elektronische Schaltung realisiert werden. Umfaßt das Gehäuse außer der elektronischen Schaltung elektrische Bauteile, beispielsweise einen Elektromotor, so kann der Kontakt zum elektrischen Bauteil durch eine separate Steckverbindung, d.h. mit einem Kabel und einem Stecker, der auf Kontaktstifte im Inneren des Gehäuses aufgesteckt wird, erfolgen, vorteilhafter jedoch wird das elektrische Bauteil selbst direkt auf die Kontaktstifte aufgesteckt. Insbesondere mit der letzten Variante können mehrere Arbeitsschritte eingespart werden.

Das erfindungsgemäße Formteil besteht aus mindestens einem thermoplastischen Kunststoff oder Kunststoff-Blend und kann wahlweise auch verstärkt sein. Für Anwendungen in der Maschinen- und Fahrzeugtechnik sind als Kunststoffe besonders Polyacetale, insbesondere Polyoxymethylenhomo- und Copolymere (POM), Polyester, insbesondere Polyethylenterephthalat (PET) und Polybutylenterephthalat (PBT), Polyarylether und -sulfide, insbesondere Polyphenylenoxid (PPO) und -sulfid (PPS), Polyolefine, insbesondere hoch- und niedermolekulares Polyethylen (PE) und Polypropylen (PP), Polyamide (PA), Polycarbonate (PC), cycloolefinische Homo- und Copolymere (COC) sowie flüssigkristalline (LCP) Polymere bevorzugt. Bevorzugte Kunststoff-Blends sind schlagzähe Mischungen beispielsweise mit thermoplastischen Elastomeren oder Acrylnitril-Styrol-Blends, aber auch Mischungen der vorgenannten Kunststoffe untereinander.

Der thermoplastische Kunststoff kann übliche Additive und Zusatzstoffe wie Stabilisatoren, Antioxidantien, Flammschutzmittel etc. sowie Farbmittel, Füll- und Verstärkungsstoffe enthalten. Um eine besondere Festigkeit des Formteils zu gewährleisten kann es auch vorteilhaft sein, als Verstärkungsmittel neben anderen oder an Stelle anderer feiner Partikel mit einer mittleren Teilchenlänge < 0,5 mm, insbesondere Kurzglasfasern, Partikel mit einer mittleren Teilchenlänge > 0,5 mm, insbesondere > 1 mm oder gar > 5 mm zu verwenden, beispielsweise langglasfaserverstärktes Polyolefin oder Polyamid. Insbesondere bei Zugabe von Ruß zur Schwarzfärbung des Formteils ist darauf zu achten, daß der Kunststoff nicht leitfähig wird und Kriechströme oder Kurzschlüsse verursacht.

Die Leiterbahnen können durch allgemein bekannte Verfahren wie Heißprägen oder galvanische Techniken auf die Oberfläche des Kunststoffs aufgetragen werden. Im Sinne der Einsparung von Arbeitsschritten bei der Fertigung des erfindungsgemäßen Formteils ist der Auftrag durch Aufprägen von Metallfolien zu bevorzugen. In diese Leiterbahnen werden an den vorbestimmten Stellen Kontaktstifte eingeschossen. Dies geschieht wahlweise so, daß der Kontaktstift anschließend im Kunststoff steckend mit einem Ende von der Leiterbahn absteht oder durch die Kunststoffschicht hindurch tretend mit einem Ende auf der entgegengesetzten Seite aus dem Kunststoff herausragt, wobei das andere Ende des Kontaktstifts mit der Oberfläche der Leiterbahn abschließt oder zusätzlich auch von dieser absteht.

Besonders ökonomisch wird das Verfahren zur Herstellung des erfindungsgemäßen Formteils, wenn es in einem Werkzeug durchgeführt wird. Beispielsweise kann in einem Spritzgußwerkzeug der Rohling geformt werden, wobei vorteilhaft durch die Anordnung von Stiften auf der Werkzeuginnenseite Löcher im Kunststoffteil entstehen, in die später die Kontaktstifte eingeschossen werden. Auf den Rohling werden dann durch Heißprägen die Leiterbahnen aufgebracht, in die abschließend die Kontaktstifte eingeschossen werden.

Eine ebenso vorteilhafte Verfahrensvariante besteht darin, eine Folie mit den Leiterbahnen und den eingesteckten Kontaktstiften im Spritzgußwerkzeug vorzulegen und dann mit dem Kunststoff zu umspritzen.

Die Kontaktstifte haben in der Regel eine einfache zylindrische Form. Zur Verbesserung des Kontakts mit der Leiterbahn ist es jedoch vorteilhaft, wenn die Kontaktstifte an der Stelle, mit der sie nach dem Einschießen mit der Leiterbahn in Kontakt stehen einen größeren Querschnitt aufweisen. Derartige Stifte sind weitläufig bekannt. Zur Verbesserung der Kontaktierung kann die Verbindung zwischen Kontaktstift und Leiterbahn mit einem Leitkleber oder, insbesondere bei glasfaserverstärkten Kunststoffen mit einem Lot bedeckt werden. Bei Kontaktstiften, die durch den Kunststoff hindurch treten wird durch das Verkleben oder Verlöten zudem Verhindert, daß Feuchtigkeit durch das Loch, in dem der Kontaktstift steckt, hindurch diffundiert und in das Innere des Gehäuses gelangt.

Die Dicke der Leiterbahnen ist den speziellen Anforderungen einer Anwendung entsprechend auszuwählen. Üblich sind Dicken von 35 bis 100 µm. Zum besonderen Schutz können die Leiterbahnen auch mit einer weiteren Kunststoffschicht bedeckt werden, wobei der dazu verwendete Kunststoff nicht der selbe sein muß, aus dem das Formteil gefertigt wird.

Das erfindungsgemäße Formteil findet beispielsweise als Türschloßgehäuse, als Gehäuse für Fensterheber- oder Scheibenwischergetriebe, in Form eines Türmoduls mit integrierten elektrischen Leitungen und Kontakten, für Tankgeber oder für Verteilerboxen Verwendung. Je nach Verwendung kann es dabei erforderlich sein, das Formteil zusätzlich mit einer Dichtung oder Befestigungselementen zu versehen. Dies geschieht vorteilhaft ebenfalls in einem Arbeitsgang mit der Herstellung des Formteils, beispielsweise im Mehrkomponentenspritzgußverfahren, kann aber auch in einem gesonderten Arbeitsschritt erfolgen.

Die folgenden Ausführungsbeispiele sollen die Erfindung für den Fachmann verdeutlichen ohne jedoch einen einschränkenden Charakter zu haben.

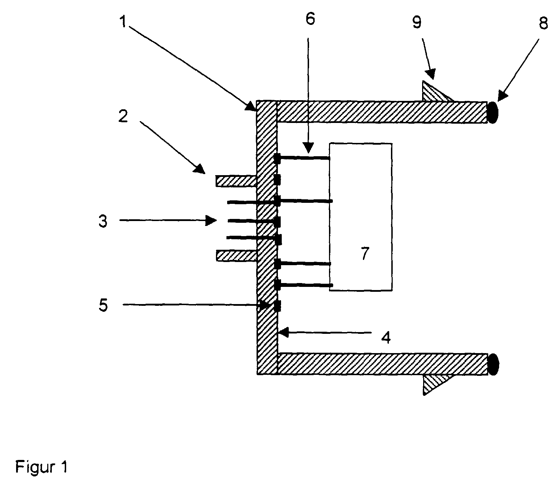

Figur 1 zeigt im Querschnitt ein Kunststoffgehäuse 1, das nach außen hin eine Steckverbindung 2 mit drei nach außen ragenden Kontaktstiften 3 aufweist. Auf der Innenseite 4 befinden sich Leiterbahnen 5, mit Kontaktstiften 6, auf die eine elektronische Baugruppe 7 aufgesteckt ist. Das Kunststoffgehäuse 1 ist mit einer Dichtung 8 und Befestigungselementen 9 versehen.

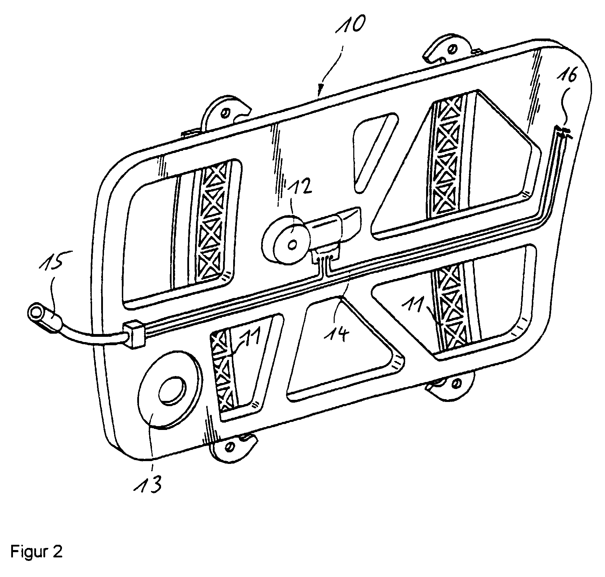

Figur 2 zeigt einen einstückigen Türmodul 10 aus Kunststoff mit integrierten Fensterheberschienen 11, einer Halterung 12 für ein Fensterhebergetriebe mit Motor und einer Vertiefung 13 für einen Lautsprecher. Der Türmodul weist aufgeprägte Leiterbahnen 14 auf, die von einer zentralen Stromversorgung 15 zur Halterung 12 und zu anderen Positionen des Türmoduls verlaufen und dort an Kontaktstiften 16 enden, auf die in der Figur nicht gezeigte elektrische oder elektronische Vorrichtungen, beispielsweise das Fensterhebergetriebe mit Motor, aufgesteckt werden können. Da das Fensterhebergetriebe rückseitig an den Türmodul anzubringen ist, schließen die in der Halterung 12 eingeschossenen Kontaktstifte 16 diesseitig eben mit den Leiterbahnen ab und man sieht nur ihre mit Leitkleber abgedeckten Enden.

## Patentansprüche

1. Kunststofformteil, das auf einer Seite auf seiner Oberfläche elektrische Leiterbahnen aufweist, in die Kontaktstifte eingebracht sind, wobei ein Teil dieser Kontaktstifte von der Oberfläche mit den elektrischen Leiterbahnen absteht und ein Teil der Kontaktstifte durch die Kunststoffschicht hindurch dringt und auf der anderen, entgegengesetzten Seite herausragt.

2. Kunststofformteil nach Anspruch 1 in Form eines Gehäuses für elektrische oder elektronische Vorrichtungen und Bauteile, bei denen die Leiterbahnen durch eingeschossene Kontaktstifte elektrisch kontaktiert werden.

3. Kunststofformteil nach Anspruch 1 oder 2, dadurch gekennzeichnet, daß das Formteil aus mindestens einem thermoplastischen Kunststoff oder Kunststoff-Blend besteht.

4. Kunststofformteil nach Anspruch 3, dadurch gekennzeichnet, daß als thermoplastischer Kunststoff Polyacetal, insbesondere Polyoxymethylenhomo- oder Copolymer, Polyester, insbesondere Polyethylenterephthalat oder Polybutylenterephthalat, Polyarylether oder -sulfid, insbesondere Polyphenylenoxid oder -sulfid, Polyolefin, insbesondere hoch- oder niedermolekulares Polyethylen oder Polypropylen, Polyamid, Polycarbonat, cycloolefinisches Homo- oder Copolymer, flüssigkristallines Polymer oder eine Mischung davon eingesetzt wird.

5. Kunststofformteil nach Anspruch 3, dadurch gekennzeichnet, daß als Kunststoff-Blend eine schlagzäh modifizierte Polymermischung, insbesondere eine Mischung mit mindestens einem thermoplastischen Elastomeren oder Acrylnitril-Styrol-Blend eingesetzt wird.

6. Kunststofformteil nach einem der Ansprüche 1 bis 5, dadurch gekennzeichnet, daß es zusätzlich mindestens eine integrierte Dichtung und/oder mindestens ein integriertes Befestigungselement enthält.

7. Baugruppe umfassend ein Gehäuse aus mindestens einem thermoplastischen Kunststoff oder Kunststoff-Blend, das an ausgewählter Stelle an seiner Innenseite auf der Oberfläche elektrische Leiterbahnen aufweist, in die Kontaktstifte eingebracht sind, wobei ein Teil dieser Kontaktstifte von der Oberfläche mit den elektrischen Leiterbahnen absteht und ein Teil der Kontaktstifte durch die Kunststoffschicht des Gehäuses hindurch dringt und ausschließlich oder zusätzlich auf der entgegengesetzten Außenseite herausragt, sowie mindestens eine elektrische oder elektronische Vorrichtung.

8. Baugruppe nach Anspruch 7, dadurch gekennzeichnet, daß die elektrische oder elektronische Vorrichtung ausgewählt ist aus Elektromotor- und Getriebeeinheiten und elektronischen Bauteilen.

9. Verfahren zur Herstellung eines Formteils nach einem der Ansprüche 1 bis 6, dadurch gekennzeichnet, daß in einem Spritzgußwerkzeug ein Rohling geformt wird, wobei durch die Anordnung von Stiften auf der Werkzeuginnenseite Löcher im Kunststoffteil entstehen, auf den Rohling durch Heißprägen oder Folienhinterspritzung Leiterbahnen aufgebracht, und anschließend Kontaktstifte durch die Leiterbahnen in die vorgefertigten Löcher eingeschossen werden.

10. Verfahren zur Herstellung eines Formteils nach einem der Ansprüche 1 bis 6, dadurch gekennzeichnet, daß in einem Spritzgußwerkzeug eine Folie mit Leiterbahnen und eingesteckten Kontaktstiften vorgelegt und anschließend mit dem Kunststoff oder Kunststoff-Blend umspritzt wird.
